(19) Europäisches Patentamt / European Patent Office / Office européen des brevets

(11) **EP 3 735 706 B1**

(12) **EUROPÄISCHE PATENTSCHRIFT**

(45) Veröffentlichungstag und Bekanntmachung des Hinweises auf die Patenterteilung:
**20.10.2021   Patentblatt 2021/42**

(21) Anmeldenummer: **19708807.3**

(22) Anmeldetag: **27.02.2019**

(51) Int Cl.:
*H01L 23/373* (2006.01)        *H05K 1/03* (2006.01)
*H05K 3/28* (2006.01)

(86) Internationale Anmeldenummer:
**PCT/EP2019/054787**

(87) Internationale Veröffentlichungsnummer:
**WO 2019/166454 (06.09.2019 Gazette 2019/36)**

(54) **METALL-KERAMIK-SUBSTRAT UND VERFAHREN ZUR HERSTELLUNG EINES METALL-KERAMIK-SUBSTRATS**

METAL-CERAMIC SUBSTRATE AND METHOD FOR PRODUCING A METAL-CERAMIC SUBSTRATE

SUBSTRAT EN MÉTAL-CÉRAMIQUE ET PROCÉDÉ DE PRODUCTION D'UN SUBSTRAT EN MÉTAL-CÉRAMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2018   DE 102018104532**

(43) Veröffentlichungstag der Anmeldung:
**11.11.2020   Patentblatt 2020/46**

(73) Patentinhaber: **Rogers Germany GmbH**
**92676 Eschenbach (DE)**

(72) Erfinder:
• **TANG, Xinhe**
**92676 Eschenbach (DE)**
• **MEYER, Andreas**
**93173 Wenzenbach (DE)**
• **BRITTING, Stefan**
**91220 Schnaittach (DE)**

(74) Vertreter: **Müller Schupfner & Partner**
**Patent- und Rechtsanwaltspartnerschaft mbB**
**Bavariaring 11**
**80336 München (DE)**

(56) Entgegenhaltungen:
DE-A1-102013 013 842     JP-A- H03 145 748
JP-A- 2004 296 465

**Beschreibung**

Die vorliegende Erfindung betrifft ein Metall-Keramik-Substrat für elektrische, insbesondere elektronische Bauteile und ein Verfahren zur Herstellung eines Metall-Keramik-Substrats.

Metall-Keramik-Substrate sind beispielsweise als Leiterplatten oder Platinen aus dem Stand der Technik hinlänglich bekannt. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht und eine an die Isolationsschicht angebundene Metallisierungsschicht. Wegen ihrer vergleichsweise hohen Isolationsfestigkeiten und ihrer Stabilität gegenüber Umwelteinflüssen haben sich aus Keramik gefertigte Isolationsschichten als besonders vorteilhaft erwiesen. Durch eine Strukturierung der Metallisierungsschicht können sodann Leiterbahnen und/oder Anschlussflächen für die elektrischen Bauteile realisiert werden.

Als Schwachstelle hinsichtlich einer gewünschten bzw. erforderlichen Temperaturwechselbeständigkeit erweist sich regelmäßig eine Grenzregion zwischen der Metallisierungsschicht und der Isolationsschicht entlang einer Kante, die die Metallisierungsschicht begrenzt. Durch unterschiedliche thermische Ausdehnungskoeffizienten, nämlich i. d. R. einem gegenüber dem thermischen Ausdehnungskoeffizienten der Metallisierungsschicht geringeren thermischen Ausdehnungskoeffizienten der Isolationsschicht, kommt es entlang einer Anbindungsfläche, entlang der die Metallisierungsschicht an die Isolationsschicht angebunden ist, zu Scherspannungen. Diese Scherspannungen werden an der Kante, die die Anbindungsfläche begrenzt, maximal und fördern eine Rissbildung in diesem Bereich.

Zur Verbesserung der Temperaturwechselbeständigkeit schlägt die EP 0 632 681 A2 Materialschwächungen in der Metallisierungsschicht, insbesondere in dessen Randbereich, vor. Die DE 10 2010 024 520 A1 lehrt hingegen Gräben in der Metallisierungsschicht mit einem Füllmaterial zu bedecken, um Risse zu verfüllen. DE 10 2013 013842 A1 beschreibt ein Verfahren zum Herstellen von Metall-Keramik-Substraten mit einer Keramikschicht und mit wenigstens einer Metallisierung. In dem Verfahren werden Risse, die am Randbereich der wenigstens einen Metallisierung zwischen der Keramik der Keramikschicht und dem Metall der wenigstens einen Metallisierung vorhanden sind mit einer aushärtbaren oder polymerisierbaren Verschließ- oder VerpressMasse ausgefüllt. Diese Verschließ- oder Verpressmasse wird ausschließlich in den Rissen aufgenommen.

Ausgehend von diesem Hintergrund macht es sich die vorliegende Erfindung zur Aufgabe, ein Metall-Keramik-Substrat bereitzustellen, dessen Temperaturwechselbeständigkeit weiter verbessert ist und insbesondere dessen Veranlagung zur Rissbildung reduziert ist.

Diese Aufgabe wird gelöst durch ein Metall-Keramik-Substrat gemäß Anspruch 1 und ein Verfahren gemäß Anspruch 9. Weitere Vorteile und Merkmale der Erfindung ergeben sich aus den Unteransprüchen sowie der Beschreibung und den beigefügten Figuren.

Erfindungsgemäß ist ein Metall-Keramik-Substrat vorgesehen, wobei das Metall-Keramik-Substrat

- eine sich entlang einer Haupterstreckungsebene erstreckende und eine Keramik aufweisende Isolationsschicht, und

- eine Metallisierungsschicht, die an der Isolationsschicht über einer Anbindungsfläche angebunden ist, aufweist, wobei die Anbindungsfläche in einer parallel zur Haupterstreckungsebene verlaufenden Ebene durch mindestens eine Kante begrenzt ist.

Zur Erhöhung der Temperaturwechselbeständigkeit ist es dabei vorgesehen, dass die Kante zumindest teilweise mit einem Füllmaterial bedeckt ist und ein sich an die Kante anschließender bzw. angrenzender Randbereich der Metallisierungsschicht eine Materialschwächung aufweist.

Gegenüber dem Stand der Technik ist es erfindungsgemäß vorgesehen, das Bedecken der Kante mit einem Füllmaterial und eine Materialschwächung des Randbereichs der Metallisierungsschicht zu kombinieren. Es hat sich dabei überraschenderweise herausgestellt, dass die Kombination dieser beiden Maßnahmen synergetisch die Temperaturwechselbeständigkeit verbessert. D. h. die Kombination beider Maßnahmen verbessert die Temperaturwechselbeständigkeit des Metall-Keramik-Substrats mehr als die zu erwartenden Verbesserung durch die Summe der jeweiligen Maßnahmen.

Dabei macht es sich die Materialschwächung zu Nutze, dass mit abnehmender Metallisierungsschichtdicke auch thermomechanische Spannungen abnehmen. Das Bedecken der Kante mit einem Füllmaterial bewirkt, dass sich ein Volumen in einem Bereich vergrößern lässt, in dem die Scherspannungen auftreten. Zudem lassen sich Mikrorisse versiegeln. Das Versiegeln der Mikrorisse wirkt dabei einer Feuchtigkeitsaufnahme, z. B. durch eine Kapillarkondensation, entgegen und minimiert dadurch wiederum eine Spannungsrisskorrosion. Neben dem synergetischen Effekt, der sich aus der Kombination des zumindest teilweise Bedecken der Kante und der Materialschwächung ergibt, gestattet es die Kombination zudem, den Randbereich mit der Materialschwächung bei gleicher Temperaturwechselbeständigkeit zu verkürzen (im Vergleich zu einem Metall-Keramik-Substrat, bei dem ausschließlich eine Materialschwächung im Randbereich vorgesehen ist). Dadurch steht einer Bauteilseite, über die elektronische bzw. elektrische Bauteile an das Metall-Keramik-Substrat angebunden werden, eine großflächigere Anschlussfläche zur Verfügung, da in dem Bereich mit der Materialschwächung keine Anbindung von elektrischen bzw. elektronischen Bauteilen sinnvoll ist. Mit anderen Worten: die erfindungsgemäße Kombination gestattet es zusätzlich, die nutzbare Anschlussfläche bzw. Abschlussfläche der Metallisierungsschicht zu vergrößern bzw. zu optimieren.

Vorzugsweise weist die Isolationsschicht $Al_2O_3$, $Si_3N_4$, AlN, ZTA (Zirkonia toughened Alumina), MgO, BeO, SiC oder hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Als Materialien für die Metallisierungsschicht sind Kupfer, Aluminium, Molybdän und/oder deren Legierungen sowie Laminate, wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von der zweiten Kupferschicht unterscheidet, vorstellbar.

Insbesondere ist es vorgesehen, dass sich die Anbindungsfläche nicht über die gesamte Länge der Isolationsschicht entlang der Haupterstreckungsebene erstreckt. Mit anderen Worten: die Isolationsschicht steht in Richtung der Haupterstreckungsebene gegenüber der Metallisierungsschicht, insbesondere gegenüber der Kante, vor. Vorzugsweise ist die Metallisierungsschicht strukturiert und die Kante entsteht in Folge einer Strukturierungsmaßnahme, z. B. einem Ätzen oder einem Oberflächenfräsen von Isolationsgräben. Unter einer Materialschwächung ist insbesondere eine Variation bzw. Modulation in der Metallisierungsschichtdicke zu verstehen. Vorzugsweise beträgt ein Verhältnis einer Erstreckung des Randbereichs zu einer in dieselbe Richtung bemessene Gesamtlänge der Metallisierungsschicht einen Wert von weniger als 0,25, bevorzugt weniger als 0,15 und besonders bevorzugt weniger als 0,1. Dabei bemisst sich die Erstreckung bzw. die Gesamtlänge insbesondere in einer senkrecht zum Verlauf der Kante orientierten Richtung. Insbesondere beginnt die Messung der Erstreckung mit der Kante und ist auf einen Zentralbereich der Metallisierungsschicht gerichtet.

Weiterhin ist es bevorzugt vorgesehen, dass eine dem Randbereich zugeordnete Außenfläche, d. h. der Isolationsschicht abgewandte Seite der Metallisierungsschicht, kleiner ist als ein 0,15-faches, bevorzugt kleiner als ein 0,1-faches und besonders bevorzugt kleiner als ein 0,05- faches der von der Isolationsschicht abgewandten Gesamtaußenfläche der Metallisierungsschicht. Vorzugsweise ist es vorgesehen, dass der Randbereich sich ausgehend von der Kante in einer senkrecht zum Verlauf der Kante in der Haupterstreckungsebene bis zu 1000 µm, bevorzugt bis zu 800 µm und besonders bevorzugt bis zu 600 µm in Richtung des Zentralbereichs der Metallisierungsschicht erstreckt. Es ist auch vorstellbar, dass der Randbereich sich durch die Ausdehnung der Materialschwächung definiert und sich beispielsweise in Richtung des Zentralbereichs bis zu einem Bereich der Metallisierungsschicht erstreckt, in dem die Metallisierungssicht ihre maximale Dicke bzw. eine konstante Dicke aufweist und keine weitere Ausnehmungen vorgesehen sind.

Die Kante bildet dabei für die Anbindungsfläche eine linienförmige Grenze, die zumindest bereichsweise gebogen, gerade oder eckig sein kann. Insbesondere ist die Kante Teil des Randbereichs bzw. bildet den vom Zentralbereich abgewandten Abschluss der Anbindungsfläche bzw. des Randbereichs. Dabei umschließt bzw. umgibt die Kante die Anbindungsfläche vollständig, d. h. zur jeder Seite ihrer Erstreckung in der Haupterstreckungsebene.

Weiterhin ist es bevorzugt vorgesehen, dass die Kante umlaufend, insbesondere vollständig, mit dem Füllmaterial bedeckt ist. Dabei ist das Füllmaterial dazu geeignet die Rissbildung an der Kante zu unterdrücken, d.h. eine Ausdehnung des Risses zu hemmen oder sogar gänzlich zu verhindern Vorzugsweise umfasst das Füllmaterial ein Kunststoffmaterial, wie Polyimid, Polyamide, Epoxid oder Polyetheretherketon. Es ist dabei auch vorstellbar, dass dem Kunststoffmaterial ein Keramikanteil zugefügt ist. Beispiele für einen solchen Zusatzstoff sind Siliziumnitrid, Aluminiumnitrid, Aluminiumoxid oder Glas.

Es ist auch vorstellbar, dass dem Kunststoffmaterial Kohlefasern, Glasfasern und/oder Nanofasern beigefügt sind. Vorzugsweise ist es vorgesehen, dass das Füllmaterial hitzebeständig ist, d. h. das Füllmaterial schmilzt nicht bei Temperaturen, die bei der Herstellung des Metall-Keramik-Substrats nach dem Aufbringen des Füllmaterials und/oder beim Löten auftreten. Weiterhin ist es bevorzugt vorgesehen, dass das Füllmaterial geeignet ist, eine feste und gute Bindung mit der Isolationsschicht, vorzugsweise dem gewählten Keramikmaterial, und der Metallisierungsschicht, vorzugsweise dem gewählten Metall, wie Kupfer, einzugehen. Weiterhin ist es vorgesehen, dass der thermische Ausdehnungskoeffizient des Füllmaterials gleich oder größer ist als der thermische Ausdehnungskoeffizient der Isolationsschicht und/oder der Metallisierungsschicht. Beispielsweise ist der thermische Ausdehnungskoeffizient des Füllmaterials mehr als dreimal so groß wie der thermische Ausdehnungskoeffizient der Metallisierungsschicht.

Es ist auch vorstellbar, dass das Füllmaterial einen Teil eines Gehäuses bildet. Beispielsweise lässt sich das Metall-Keramik-Substrat während des Umspritzens zum Ausbilden eines Gehäuses realisieren, indem beim Umspritzen die Kante mit dem Füllmaterial bedeckt wird. Weiterhin ist es vorstellbar, dass eine weitere Metallisierungsschicht vorgesehen ist, die auf der der Metallisierungsschicht gegenüberliegenden Seite der Isolationsschicht angebunden ist. Vorzugsweise ist die weitere Metallisierungsschicht über eine weitere Anbindungsfläche an die Isolationsschicht angebunden. Insbesondere wird die Kante an der weiteren Anbindungsfläche zumindest bereichsweise mit Füllmaterial bedeckt.

Weiterhin ist es vorstellbar, dass das Füllmaterial eine die Isolationsschicht in der Haupterstreckungsebene begrenzende Seitenfläche der Isolationsschicht zumindest teilweise bedeckt. Bevorzugt bedeckt bzw. ummantelt das Füllmaterial die Seitenfläche vollständig. Dabei erstreckt sich das Füllmaterial beispielsweise von der Kante der Anbindungsfläche bis zur in der Haupterstreckungsebene nächstgelegenen Seitenfläche der Isolationsschicht. Dabei verläuft die Seitenfläche vorzugsweise senkrecht zur Anbindungsfläche. Vorzugsweise füllt das Füllmaterial den Isolationsgraben vollständig, d. h. bis zu einer Höhe einer weiteren Kante, die die Abschlussfläche der Metallisierung in einer parallel zur Haupterstreckungsebene an der Oberseite begrenzt.

Insbesondere ist es vorgesehen, dass zur Bedeckung der Kanten das Füllmaterial, insbesondere das flüssige Füllmaterial, in die Isolationsgrabenbereiche eingeleitet wird und diese beispielsweise von unten nach oben füllt. Insbesondere werden die Isolationsgrabenbereiche bis zu einer weiteren Kante, die die Abschlussfläche der Metallisierungsschicht in einer parallel zur Haupterstreckungsebene verlaufenden Ebene begrenzt, gefüllt. Es ist auch vorstellbar, dass das Füllmaterial mittels eines Spritz- bzw. Sputterverfahren aufgetragen wird.

Um die Anbindung des Füllmaterials, insbesondere an die Isolationsschicht, zu begünstigen, ist es bevorzugt vorgesehen, dass die Isolationsschicht und/oder Metallisierungsschicht oberflächenmodifiziert ist. Beispielsweise wird die Isolationsschicht vor dem Anbinden des Füllmaterials einer Plasmabehandlung unterzogen oder die Metallisierungsschicht ist oxidiert. Dadurch lässt sich mit Vorteil die Anbindung des Füllmaterials stärken, was sich positiv auf die Lebensdauer des gefertigten Metall-Keramik-Substrats auswirkt.

Weiterhin ist es vorstellbar, dass das Füllmaterial mehrschichtig die Kante bedeckt. Dabei ist es vorstellbar, dass verschiedene Schichten unterschiedlicher Füllmaterialien übereinander angeordnet sind. Dadurch kann die Bedeckung der Kante mit Vorteil noch besser an die zu erwartenden Belastungen angepasst werden.

Gemäß einer bevorzugten Ausführungsform der vorliegenden Erfindung ist es vorgesehen, dass die Materialschwächung als Aussparung, insbesondere kuppelförmige Aussparung ausgebildet ist. Insbesondere ist die Aussparung eingelassen in eine Abschlussfläche der Metallisierungsfläche, wobei die Abschlussfläche der Anbindungsfläche gegenüberliegt und parallel zur Anbindungsfläche verläuft. Die Abschlussfläche wird bevorzugt durch eine weitere Kante begrenzt und die Aussparung ist insbesondere gegenüber der weiteren Kante in einer parallel zur Haupterstreckungsebene verlaufenden Richtung versetzt. Beispielsweise ist es vorgesehen, dass die Aussparung nicht an die weitere Kante angrenzt bzw. einen Teil der weiteren Kante bildet. Vorzugsweise sind die Aussparungen entlang einer oder mehrerer parallel zur weiteren Kante verlaufenden Reihe versetzt zueinander angeordnet. Es ist aber auch vorstellbar, dass die Aussparungen statistisch verteilt sind im Randbereich und/oder eine Dichte (d. h. eine Anzahl an Aussparungen pro Flächeneinheit) in Richtung des Zentralbereichs der Metallisierungsschicht variiert, beispielsweise abnimmt.

Vorzugsweise ist es vorgesehen, dass das Füllmaterial bis zu einer weiteren Kante reicht, die die Abschlussfläche der Metallisierung in einer parallel zur Haupterstreckungsebene verlaufenden Ebene an der Oberseite begrenzt. Weiterhin ist es bevorzugt vorgesehen, dass das Füllmaterial in einer senkrecht zur Haupterstreckungsebene verlaufenden Richtung bündig mit der weiteren Kante abschließt oder zwischen der Kante und der weiteren Kante abschließt.

In einer weiteren Ausführungsform ist es vorgesehen, dass das Füllmaterial die weitere Kante übergreift und eine Aussparung an der Oberseite der Metallisierung füllt. Dadurch wird der Randbereich in vorteilhafter Weise bis zur Aussparung mit dem Füllmetarial bedeckt und verschlossen.

Weiterhin ist es bevorzugt vorgesehen, dass ein Verhältnis zwischen der Metallisierungsdicke zur Füllmaterialhöhe einen Wert zwischen 0,5 und 0,9 bevorzugt zwischen 0,6 und 0,8 und besonders bevorzugt im Wesentlichen 0,75 annimmt.

Weiterhin ist bevorzugt vorgesehen, dass das Füllmaterial einen Bereich zwischen zwei Metallisierungen, d. h. in einen Isolationsgrabenbereich nicht vollständig, d.h. massiv füllt. Stattdessen weist das Füllmaterial zwischen den beiden Metallisierungen zumindest eine Aussparung oder einen rückspringenden Verlauf auf.

Weiterhin ist es bevorzugt vorgesehen, dass das Füllmaterial eine Beschichtung ausbildet. Dabei reicht das Füllmaterial, insbesondere in Gestalt einer Beschichtung, von der Isolationsschicht bis zur weiteren Kante oder erstreckt sich von der Isolationsschicht bis zu einer Stelle zwischen der Kante und der weiteren Kante.

Dabei ist es insbesondere vorgesehen, dass sich das Füllmaterial entlang der nicht-parallel zur Haupterstreckungsebene verlaufenden Seitenfläche erstreckt. Es ist ferner vorstellbar, dass die Aussparungen an der Abschlussfläche und/oder an der Anbindungsfläche der Metallisierungsschicht oder einer weiteren Metallisierungsschicht ausgebildet ist.

Beispielsweise können mehrere Reihen der Aussparungen ausgehend von der weiteren Kante der Metallisierungsschicht in Richtung des Zentralbereichs hintereinander angeordnet sein. Die Aussparungen können sich dabei sowohl über die gesamte Dicke der Metallisierungsschicht erstrecken, also durchgängig sein oder dort nur teilweise eingeätzt sein, so dass die Metallisierungsschicht an bestimmten Stellen, bevorzugt unmittelbar an der weiteren Kante, lokal lediglich geschwächt ist. Die Aussparungen greifen durch die Metallisierungsschicht durch oder münden bzw. enden, bevorzugt dom- oder kuppelförmig, im Inneren der Metallisierungsschicht. Denkbar ist auch eine Ausführungsform, in der lochartige Aussparungen und sacklochartige Bohrungen in der Metallisierungsschicht realisiert sind, wobei die Anzahl der lochartigen Aussparungen kleiner ist als die Anzahl der sacklochartigen Ausnehmungen. Vorteilhafterweise bilden mehrere Aussparungen, insbesondere mehrere nebeneinander angeordnete Aussparungen, einen mäanderförmigen, briefmarkenrandförmigen und/oder einen sägezahnförmigen Verlauf der weiteren Kante aus, wobei sich insbesondere der mäanderförmige, briefmarkenrandförmige und/oder der sägezahnförmige Verlauf über den gesamten Randverlauf bzw. die weitere Kante der Metallisierungsschicht erstreckt. Vorstellbar ist auch, dass sich der mäanderförmige, briefmarkenrandförmige und/oder sägezahnförmige Verlauf der Metallisierungsschicht nur über einen Teilbereich des gesamten Randverlaufs der Metallisierungsschicht erstreckt bzw. mehrere Teilbereich in Umlaufrichtung gesehen zueinander beabstandet aneinander anschließen. Durch die Ausbildung eines strukturierten Verlaufs der weiteren Kante wird dessen Oberflächenvergrößerung so ausgelegt, dass im Wesentlichen unabhängig vom Ort des Auftretens einer mechanischen Spannung diese vorteilhaft verteilt werden kann. Der Randverlauf kann aber auch unregelmäßige Aussparungen aufweisen, d. h. z. B. kleine und größere Aussparungen, die gemischt oder abwechselnd zueinander angeordnet sind, oder die wellenlinienförmig, rechteckförmig, parallelogrammförmig oder zackig ausgebildet sind.

Vorzugsweise ist es vorgesehen, dass eine insbesondere zur Haupterstreckungsebene nicht parallele Seitenfläche der Metallisierungsschicht zumindest abschnittsweise schräg und/oder bogenförmig verläuft. Insbesondere verbinden die Seitenflächen die Anbindungsfläche und die Abschlussfläche, vorzugsweise die Kante und die weitere Kante, miteinander. Durch den schrägen bzw. bogenförmigen Verlauf der Seitenflächen lässt sich auf vergleichsweise einfache Weise eine Materialschwächung im Randbereich realisieren. Vorzugsweise ist beim schrägen Verlauf die Seitenfläche gegenüber der Anbindungsfläche um zwischen 45 und 85 ° geneigt, besonders bevorzugt zwischen 60° und 85 ° und besonders bevorzugt zwischen 75° und 85° geneigt. Dadurch lässt sich mit Vorteil die Materialschwächung in einer parallel zur Haupterstreckungsebene verlaufenden Richtung vergleichsweise kurz dimensionieren, so dass eine möglichst große Abschlussfläche der Metallisierungsschicht für den Anschluss von elektronischen Bauteilen zur Verfügung gestellt werden kann. Weiterhin ist ein gestufter Verlauf denkbar. Insbesondere ist ein gestufter Verlauf mit unterschiedlich hohen Stufenhöhen denkbar.

In einer weiteren Ausführungsform der vorliegenden Erfindung ist es vorgesehen, dass das Füllmaterial ein organisches Vergussmaterial, vorzugsweise mit einer Kurzzeittemperaturfestigkeit von mehr als 300 °C, umfasst. Durch eine Beständigkeit des Füllmaterials gegenüber kurzfristig auf das Füllmaterial wirkende Temperaturen von mehr als 300 °C ist es in vorteilhafter Weise möglich, sicherzustellen, dass das Füllmaterial in einem späteren thermischen Prozess, wie z. B. beim Chiplöten oder Silbersintern, nicht geschwächt wird.

Vorzugsweise weist das Füllmaterial, insbesondere an seiner dicksten Stelle, eine Füllmaterialdicke von mindestens 20 $\mu$m, bevorzugt mindestens 30 $\mu$m und besonders bevorzugt mindestens 40 $\mu$m, auf. Dabei bildet das Füllmaterial auf einer der Kante abgewandten Seite eine Außenseite aus und die Füllmaterialdicke wird ausgehend von der Außenseite entlang einer senkrecht zum Verlauf der Außenseite (d. h. senkrecht zu einer Geraden, die tangential zur Außenseite verläuft) erstreckenden Messrichtung bestimmt. Es hat sich mit Vorteil herausgestellt, dass derart geringe Füllmaterialdicken bereits ausreichen, um die Kante wirkungsvoll zu bedecken. Dadurch wird eine Gefahr, die Abschlussfläche beim Bedecken der Kante durch das Füllmaterial zu verschmutzen, reduziert.

Dabei ist es vorzugsweise vorgesehen, dass ein Isolationsgrabenbereich zwischen einer Metallisierungsschicht und einer in der Haupterstreckungsebene benachbarten weiteren Metallisierungsschicht Füllmaterial aufweist bzw. die Isolationsschicht im Isolationsgrabenbereich vom Füllmaterial vollständig bedeckt bzw. benetzt ist, insbesondere wenn die Füllmaterialdicke innerhalb des Isolationsgrabenbereichs variiert. Eine solche Benetzung des Isolationsgrabens tritt nach dem Bedecken der Kante ohne Nachbehandlungsschritt auf. Demnach bedarf es hier keiner Nachbehandlung zur Herstellung eines solchen Metall-Keramik-Substrats. Es ist auch vorstellbar, dass der Isolationsgrabenbereich zumindest bereichsweise von dem Füllmaterial durch einen Nachbearbeitungsschritt befreit wird, insbesondere durch eine Laserbehandlung.

In einer weiteren Ausführungsform der vorliegenden Erfindung ist es vorgesehen, dass das Füllmaterial, insbesondere an seiner dünnsten Stelle, vorzugsweise zwischen der Metallisierungsschicht und einer benachbarten weiteren Metallisierungsschicht, eine Füllmaterialdicke von weniger als 30 $\mu$m, bevorzugt weniger als 20 $\mu$m und besonders bevorzugt weniger als 10 $\mu$m aufweist. Vorzugsweise ist es vorgesehen, dass die Füllmaterialdicke entlang einer parallel zur Haupterstreckungsebene verlaufenden Richtung variiert. Dadurch kann mit Vorteil die Füllmaterialdicke gezielt optimal an die zu erwartenden Scherspannung im Bereich der Kante angepasst werden. Gleichzeitig wird auf eine überflüssige Füllung, insbesondere zwischen zwei in einer parallel zu Haupterstreckungsebene verlaufenden Richtung zueinander benachbarten Metallisierungsschichten, d. h. der Metallisierungsschicht und einer weiteren Metallisierungsschicht.

Bevorzugt ist die Füllmaterialdicke oberhalb der Kante maximal und/oder nimmt in einer parallel zur Haupterstreckungsebene verlaufenden Richtung sowie senkrecht zum Kantenverlauf in Richtung Ätzgraben ab. Dadurch wird mit Vorteil, das Volumen mittels des Füllmaterials gezielt in einem besonders anfälligen Bereich, nämlich oberhalb der Kante, vergrößert. Dies trägt signifikant zur Verbesserung der Temperaturwechselbeständigkeit durch die Bedeckung mit dem Füllmaterial bei. Dabei ist der Begriffe oberhalb vorzugsweise in Messrichtung zu verstehen. Weiterhin hat es sich als besonders vorteilhaft herausgestellt, wenn die Füllmaterialdicke, insbesondere im Bereich der Kante oder in dem Bereich des Füllmaterials, der unmittelbar auf der Isolationsschicht angeordnet ist, möglichst flach ist, um so die Reduktion von mechanischen Spannungen weiter zu reduzieren. Vorzugsweise ist unter einem flachen Verlauf eine Neigung der Außenseite des Füllmaterials gegenüber der Anbindungsfläche von weniger als 25°, bevorzugt weniger als 15° und besonders bevorzugt weniger als 10° zu verstehen. Bevorzugt ist es vorgesehen, dass der Verlauf der Außenseite des Füllmaterials durch den Verlauf der Seitenfläche der Metallisierungsschicht vorgegeben. Vorzugsweise nimmt die Füllmaterialdicke stetig und/oder gleichmäßig ab.

Gemäß einer weiteren Ausführungsform der vorliegenden Erfindung ist es vorgesehen, dass eine Füllmaterialhöhe kleiner als eine Metallisierungsschichtdicke ist. Vorzugsweise nimmt ein Verhältnis zwischen der Füllmaterialhöhe FH zu der Metallisierungsschichtdicke MD ein Wert zwischen 0,5 und 0,9, und bevorzugt zwischen 0,6 und 0,85 an. Mit anderen Worten. Die Seitenflächen bleiben zumindest teilweise frei von Füllmaterial, insbesondere in einem der Abschlussfläche zugewandten Bereich. Dabei ist es vorgesehen, dass die Füllmaterialdicke größer ist als 10 $\mu$m, da geringere Schichtdicken als nicht mehr mechanisch relevant angenommen werden. Die Reduktion der Füllmaterialhöhe lässt sich beispielsweise dadurch realisieren, dass der Isolationsgrabenbereich nur teilweise gefüllt wird. Durch die reduzierte Füllmaterialhöhe lässt sich mit Vorteil die Wahrscheinlichkeit für eine Verunreinigung der Abschlussfläche durch das Füllmaterial beim Bedecken vermeiden. Es ist aber auch vorstellbar, dass sich die Füllmaterialhöhe bis zur weiteren Kante der Abschlussfläche erstreckt.

Darüber hinaus ist es vorgesehen, dass das Metall-Keramik-Substrat eine Keramik aufweisende Isolationsschicht mit einer ersten Dicke, und eine an der Isolationsschicht angebundene Metallisierungsschicht mit einer zweiten Dicke umfasst, wobei die zweite Dicke größer als 200 $\mu$m und die erste Dicke kleiner als 300 $\mu$m ist, wobei die erste Dicke und die zweite Dicke derart dimensioniert sind, dass ein Verhältnis

- eines Betrages der Differenz zwischen einem thermischen Ausdehnungskoeffizienten der Metallisierungsschicht und einem thermischen Ausdehnungskoeffizienten des Metall-Keramik-Substrats zum

- thermischen Ausdehnungskoeffizient des Metall-Keramik-Substrats

einen Wert kleiner als 0,25, bevorzugt kleiner als 0,2 und besonders bevorzugt kleiner als 0,15, oder sogar kleiner als 0,1 annimmt.

Gegenüber dem Stand der Technik ist es mit der gesagten Ausgestaltung bzw. Dimensionierung der ersten Dicke und der zweiten Dicke mit Vorteil möglich, eine verbesserte Temperaturwechselbeständigkeit zu realisieren, insbesondere auch für solche Metall-Keramik-Substrate, deren Wärmewiderstand durch eine vergleichsweise dünne Isolationsschicht, d. h. mit einer ersten Dicke kleiner als 250 $\mu$m, bevorzugt kleiner als 200 $\mu$m und besonders bevorzugt kleiner als 150 $\mu$m, reduziert ist. Vorzugsweise werden hierbei zur Dimensionierung der ersten und/oder der zweiten Dicke der thermische Ausdehnungskoeffizient des Metall-Keramik-Substrats (d. h. des thermischen Gesamtausdehnungskoeffizienten, der alle Schichten, insbesondere die Isolationsschicht und die Metallisierungsschicht, berücksichtigt) und der thermische Ausdehnungskoeffizient der Metallisierungsschicht herangezogen. Es hat sich dabei überraschenderweise herausgestellt, dass sich trotz der vergleichsweise geringen ersten Dicken der Isolationsschicht die Temperaturwechselbeständigkeit verbessern lässt, sofern die zweite Dicke bzw. erste Dicke anspruchsgemäß dimensioniert werden. Insbesondere hat sich gezeigt, dass ein Ausfall eines Metall-Keramik-Substrats unter Temperaturwechseln umso geringer ist, desto kleiner die Differenz zwischen dem thermischen Ausdehnungskoeffizienten der Metallisierungsschicht und dem thermischen Ausdehnungskoeffizienten des Metall-Keramik-Substrats ist.

Ein weiterer Vorteil neben dem reduzierten Wärmewiderstand der vergleichsweise dünnen Isolationsschicht ist darin zu sehen, dass mit abnehmender Schichtdicke auch die Anzahl und Größe von Gefügefehlern sinkt. Entsprechend nimmt auch eine Wahrscheinlichkeit für das Versagen der eine Keramik ausweisenden Isolationsschicht ab. Die erste Dicke und die zweite Dicke werden dabei entlang einer senkrecht zur Haupterstreckungsebene verlaufenden Richtung bemessen, wobei die Haupterstreckungsebene parallel zur Isolationsschicht verläuft. Die Metallisierungsschicht ist dabei über eine Anbindungsfläche unmittelbar an die Isolationsschicht angebunden.

Als Temperaturwechselbeständigkeit wird vorzugsweise ein Einreißen der Isolationsschicht im Grenzbereich zu der Metallisierungsschicht verstanden. Dieses Einreißen führt wiederum mit steigender Zykluszahl zu einer Delamination. Die unter Temperaturwechseln beobachtbare Lebensdauer des Metall-Keramik-Substrats endet dabei, wenn mittels US-Mikroskopie ein Riss nachweisbar ist, der wiederum den Wärmeabtransport unterhalb der Wärmequellen bzw. im Bereich der halben Kupferdicke um die Wärmequelle herum behindert bzw. die Isolationsfestigkeit des Substrates einschränkt. Es hat sich herausgestellt, dass die unter Temperaturwechsel beobachte Lebensdauer verlängert werden kann, wenn das Metall-Keramik-Substrat anspruchsgemäß dimensioniert wird.

Vorzugsweise weist die Isolationsschicht $Al_2O_3$, $Si_3N_4$, AlN, eine HPSX-Keramik (d. h. eine Keramik mit einer $Al_2O_3$- Matrix, die einen x-prozentigen Anteil an $ZrO_2$ umfasst, beispielsweise $Al_2O_3$ mit 9% $ZrO_2$= HPS9 oder $Al_2O_3$ mit 25% $ZrO_2$= HPS25), SiC, BeO, MgO, oder hochdichtes MgO (> 90% der theoretischen Dichte), TSZ (tetragonal stabilisiertes Zirkonoxid) als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Als Materialien für die Metallisierungsschicht sind Kupfer, Aluminium, Molybdän und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar.

Weiterhin ist es vorstellbar, dass die Isolationsschicht zum Beispiel aus zirkonaverstärktem Aluminiumoxidumfasst, was mit Vorteil die Stabilität der Isolationsschicht erhöht, während beispielsweise eine Isolationsschicht aus $Al_2O_3$ vergleichsweise günstig produzierbar ist.

Beispielsweise weist eine Isolationsschicht aus der Keramik HPS9 eine erste Dicke von 0,26 mm oder 0,32 mm auf, wenn die zweite Dicke der aus Kupfer gefertigten Metallisierungsschicht einen Wert von im Wesentlichen 0,6 mm annimmt.

Gemäß einer weiteren Ausführungsform der vorliegenden Erfindung ist es vorgesehen, dass die erste Dicke größer als 30 $\mu$m, bevorzugt größer als 60 $\mu$m und besonders bevorzugt größer als 90 $\mu$m ist. Es hat sich herausgestellt, dass solche ersten Dicken eine entsprechende Isolationsfestigkeit und Stabilität des Metall-Keramik-Substrats sicherstellen können. Zudem ist ein Fertigungsaufwand für Isolationsschichten mit einer ersten Dicke von mehr als 90 $\mu$m geringer als derjenige für dünner dimensionierte Isolationsschichten.

Vorzugsweise ist es vorgesehen, dass auf der der Metallisierungsschicht gegenüberliegenden Seite an der Isolationsschicht eine weitere Metallisierungsschicht mit einer dritten Dicke angebunden ist, wobei die erste Dicke, die zweite Dicke und/oder die dritte Dicke derart dimensioniert sind, dass ein Verhältnis

- eines Betrages der Differenz zwischen einem thermischen Ausdehnungskoeffizienten der weiteren Metallisierungsschicht und/oder der Metallisierungsschicht und einem thermischen Ausdehnungskoeffizienten des Metall-Keramik-Substrats zum

- thermischen Ausdehnungskoeffizienten des Metall-Keramik-Substrats

- einen Wert kleiner als 0,25, bevorzugt kleiner als 0,2 und besonders bevorzugt kleiner als 0,15, oder sogar kleiner als 0,1 annimmt.

Vorzugsweise ist das Metall-Keramik-Substrat thermomechanisch symmetrisch ausgebildet. Insbesondere sind die Metallisierungsschicht, die Isolationsschicht und die weitere Metallisierungsschicht entlang einer senkrecht zur Haupterstreckungsebene verlaufenden Stapelrichtung übereinander angeordnet. Dabei bemisst sich die dritte Dicke in einer senkrecht zur Haupterstreckungsebene verlaufenden Richtung. Vorzugsweise wird der thermische Ausdehnungskoeffizient der weiteren Metallisierungsschicht oder der Metallisierungsschicht ausgewählt, der näher am thermischen Ausdehnungskoeffizienten des Metall-Keramik-Substrats liegt. Für den Fachmann ist es ersichtlich, dass die formulierten Bedingungen auf Metall-Keramik-Substrate übertragbar sind, die aus mehr als drei Schichten zusammengesetzt sind. Vorzugsweise lässt sich ein solches mehrschichtiges Metall-Keramik-Substrat mit mehr als drei Schichten auf ein Metall-Keramik-Substrat mit einer Isolationsschicht, einer Metallisierungsschicht und einer weiteren Metallisierungsschicht übertragen, d. h. ein dreischichtiges Metall-Keramik-Substrat. Vorzugsweise ist das Material für die zweite Metallisierungsschicht derart gewählt, dass es die Steifigkeit des gesamten Metall-Keramik-Substrats erhöht. Dadurch lässt sich gezielt die mechanische Belastbarkeit des gesamten Metall-Keramik-Substrats anpassen. Es ist dabei vorstellbar, dass sich hierzu das Material für die erste Metallisierungsschicht von dem Metall der zweiten Metallisierungsschicht unterscheidet. Beispielsweise handelt es sich bei dem Material für die weitere Metallisierungsschicht um Molybdän. Als Materialien für die weitere Metallisierungsschicht sind ebenfalls Kupfer, Aluminium, Wolfram und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar. Desweiteren sind auch Rückseitenmatellisierungen auf Basis von MMC's wie z.B. CuSiC, CuC, AlSiC oder MgSiC denkbar, deren CTE insbesondere an den kombinierten CTE des Substrates angepasst werden kann. Besonders bevorzugt ist es vorgesehen, dass die weitere Metallisierungsschicht zwischen 1,1 und 10 mal so dick ist, vorzugsweise zwischen 1,5 und 8 und besonders bevorzugt zwischen 2 und 6 mal so dick ist wie die Metallisierungsschicht.

Vorzugsweise ist die weitere Metallisierungsschicht zur Stabilisierung frei von Unterbrechungen, insbesondere frei von Isolationsgräben. Dadurch lässt sich vermeiden, dass das Metall-Keramik-Substrat im Bereich der Isolationsgräben nur von der dünnen Isolationsschicht gebildet wird und entsprechend anfällig für einen Bruch in diesem Bereich ist. Mit anderen Worten: die weitere Metallisierungsschicht dient als Stabilisierungsschicht für die vergleichsweise dünne Isolationsschicht. Es ist auch vorstellbar, dass die Metallisierung und die weitere Metallisierung derart gestaltet sind, dass entlang der Stapelrichtung Isolationsgräben in der Metallisierungsschicht und die Isolationsgräben in der weiteren Metallisierungsschicht nicht übereinander angeordnet sind. Es hat sich zudem herausgestellt, dass sich trotz der asymmetrischen Ausgestaltung der weiteren Metallisierungsschicht und der Metallisierungsschicht vergleichsweise große Lebensdauern realisieren lassen. Vorzugsweise erstreckt sich die weitere Metallisierungsschicht in einer parallel zur Haupterstreckungsebene verlaufenden Richtung weiter als die Metallisierungsschicht. D. h. die weitere Metallisierungsschicht ragt in einer parallel zur Haupterstreckungsebene verlaufenden Richtung gegenüber der Metallisierungsschicht vor. Denkbar ist auch, dass die weitere Metallisierungsschicht dicker ist als die Metallisierungsschicht, um für eine ausreichende Stabilität des Metall-Keramik-Substrats zu sorgen. Mit anderen Worten: Mittels der dickeren weiteren Metallisierungsschicht wird die reduzierte Dicke der Isolationsschicht zumindest teilweise kompensiert.

In einer weiteren Ausführungsform der vorliegenden Erfindung ist es vorgesehen, dass die zweite Dicke und/oder dritte Dicke größer als 350 µm und besonders bevorzugt größer als 500 µm ist. Die gegenüber der ersten Dicke größer dimensionierte zweite Dicke der Metallisierungsschicht dient mit Vorteil zur Begrenzung der Erwärmung der Leiterbahnen durch ohmsche Verluste bei einer Stromleitung ,zur Wärmespreizung unterhalb der Wärmequellen und zur Minimierung eines Durchbiegens des Metall-Keramik-Substrats. Dies kann insbesondere für Dicken oberhalb von 500 µm für eine Mehrheit der verschiedenen Metallisierungsschichten sichergestellt werden.

Vorzugsweise hängt der thermische Ausdehnungskoeffizient von einem Elastizitätsmodul, einer Poissonzahl und/oder einen materialspezifischen, thermischen Ausdehnungskoeffizienten ab. Insbesondere gilt der Zusammenhang

$$CTE = \frac{\sum_{i=1}^{n} CTE_i \cdot \frac{E_i}{(1-\eta_i)} \cdot Di}{\sum_{i=1}^{n} \frac{E_i}{(1-\eta_i)} \cdot Di},$$

wobei $Di$ die i-te Dicke von n Schichten mit dem jeweiligen $CTE_i$ bezeichnet. Zudem wird mittels der Poissonzahl $\eta_i$ die Form der jeweiligen Schicht sowie deren E-Modul $E_i$ berücksichtigt. Mittels dieses Zusammenhangs lässt sich auf Grundlage von materialspezifischen Größen und Dimensionierungsangaben der jeweilige thermische Ausdehnungskoeffizient bestimmen, wodurch ein Vergleich zwischen den jeweiligen thermischen Ausdehnungskoeffizienten möglich ist.

Zweckmäßigerweise stimmen die zweite Dicke und die dritte Dicke im Wesentlichen überein. Vorzugsweise sind die Metallisierungsschicht und die weitere Metallisierungsschicht aus demselben Material gefertigt. Es ist auch vorstellbar, dass die dritte Dicke und/oder die Materialwahl der weiteren Metallisierungsschicht angepasst sind, um eine gewünschte Größendimensionierung der Metallisierungsschicht und der Isolationsschicht zu realisieren.

Ein weiterer Aspekt der vorliegenden Erfindung ist ein weiteres Metall-Keramik-Substrat, wobei eine sich entlang einer Haupterstreckungsebene erstreckende und eine Keramik aufweisende Isolationsschicht und eine Metallisierungsschicht, die an der Isolationsschicht über einer Anbindungsfläche angebunden ist, wobei die Anbindungsfläche in einer parallel zur Haupterstreckungsebene verlaufenden Ebene durch mindestens eine Kante begrenzt ist, dadurch gekennzeichnet, dass eine Füllmaterialdicke oberhalb der Kante maximal ist und/oder in einer parallel zur Haupterstreckungsebene verlaufenden Richtung abnimmt. Alle für das vorangegangene Metall-Keramik-Substrat beschriebenen Merkmale, insbesondere in Hinblick auf die Füllmaterialdicke, und deren Vorteile lassen sich sinngemäß ebenfalls auf dieses weitere Metall-Keramik-Substrat übertragen und andersherum.

Ein weiterer Aspekt der vorliegenden Erfindung ist ein Verfahren zum Herstellen eines Metall-Keramik-Substrats, insbesondere gemäß eines erfindungsgemäße Metall-Keramik-Substrats, umfassend die Schritte:

• Bereitstellen einer sich entlang einer Haupterstreckungsebene erstreckenden und eine Keramik aufweisenden Isolationsschicht,

• Anbinden einer Metallisierungsschicht, unter Ausbildung einer Anbindungsfläche, die in einer parallel zur Haupterstreckungsebene verlaufenden Ebene durch eine Kante begrenzt ist, und

• Ausbildung einer Materialschwächung in der Metallisierungsschicht in einem sich an die Kante anschließenden Randbereich, wobei die Kante mit einem Füllmaterial bedeck wird. Alle für das erfindungsgemäße Metall-Keramik-Substrat beschriebenen Merkmale und deren Vorteile lassen sich sinngemäß ebenfalls auf das erfindungsgemäße Verfahren übertragen und andersherum.

Es hat sich dabei mit Vorteil herausgestellt, dass bei der Kombination einer Kantenbedeckung mit einer Materialschwächung im Randbereich ein Anbinden mittels eines AMB-Verfahrens und ein DCB- zu derselben Temperaturwechselbeständigkeit führt, d. h. mittels der Kombination lässt sich dieselbe Temperaturwechselbeständigkeit unabhängig vom verwendeten Verfahren erreichen. Dies ist insofern überraschend, als dass ein Anbinden mittels eines AMB-Verfahrens ohne die Kombination der besagten Maßnahmen eine dreimal bessere Temperaturwechselbeständigkeit aufweist. Damit erweist sich die erfindungsgemäß Kombination von Kantenbedeckung und Materialschwächung als besonders vorteilhaft, weil es eine flexiblere Auswahl zwischen den zur Verfügung stehenden Verfahren erlaubt, ohne eine Verschlechterung der Temperaturwechselbeständigkeit befürchten zu müssen.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:

- Oxidieren einer Kupferfolie derart, dass sich eine gleichmäßige Kupferoxidschicht ergibt;

- Auflegen des Kupferfolie auf die Keramikschicht;

- Erhitzen des Verbundes auf eine Prozesstemperatur zwischen etwa 1025 bis 1083°C, z. B. auf ca. 1071°C;

- Abkühlen auf Raumtemperatur.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca.650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Bevorzugt ist es vorgesehen, dass die Metallisierungsschicht mittels eines DCB-Verfahrens oder einem DAB-Verfahren an die Isolationsschicht angebunden wird. Es hat sich überraschender Weise herausgestellt, dass eine besonders große Verbesserung in Hinblick auf die Temperaturwechselbeständigkeit erzielen lässt, wenn die Metallisierungsschicht mittels eine DCB-Verfahrens an die Isolationsschicht angebunden wird.

Der Ausdruck im Wesentlichen bedeutet im Sinne der Erfindung Abweichungen vom jeweils exakten Wert um +/- 15 %, bevorzugt um +/- 10 % und besonders bevorzugt um +/- 5 % und/oder Abweichungen in Form von für die Funktion unbedeutenden Änderungen.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Es zeigt:

Fig.1:     ein Metall-Keramik-Substrat gemäß einer ersten bevorzugten Ausführungsform der vorliegenden Erfindung, und

Fig.2:     ein Metall-Keramik-Substrat gemäß einer zweiten bevorzugten Ausführungsform der vorliegenden Erfindung.

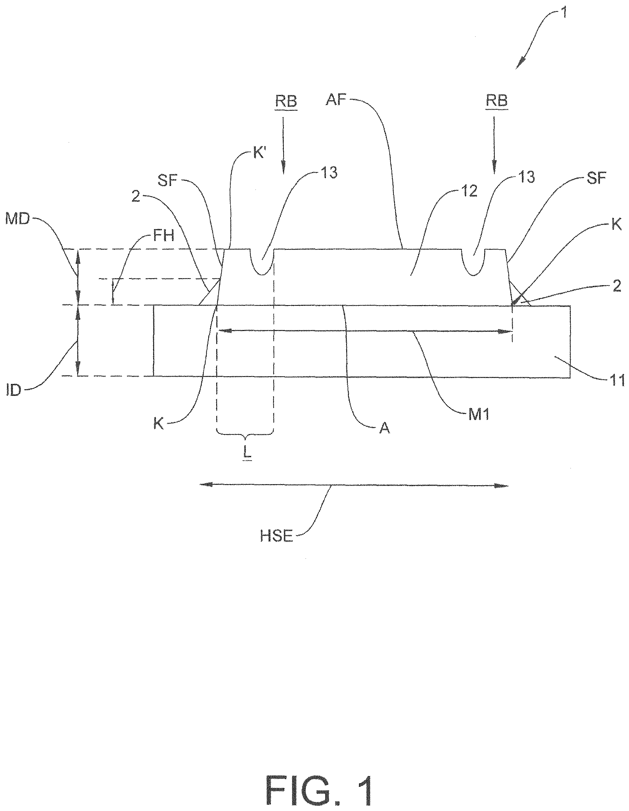

In **Figur 1** ist ein Metall-Keramik-Substrat 1 gemäß einer ersten bevorzugten Ausführungsform der vorliegenden Erfindung dargestellt. Solche Metall-Keramik-Substrate 1 dienen vorzugsweise als Träger von elektronischen bzw. elektrischen Bauteile, die an das Metall-Keramik-Substrat 1 anbindbar sind. Wesentliche Bestandteile eines solchen Metall-Keramik-Substrats 1 sind eine sich entlang einer Haupterstreckungsebene erstreckende Isolationsschicht 11 und eine an die Isolationsschicht 11 angebundene Metallisierungsschicht 12. Diese Isolationsschicht 11 ist aus mindestens einem eine Keramik umfassenden Material gefertigt. Vorstellbar ist auch, dass die Isolationsschicht 11 eine Verbundkeramik umfasst, d. h. eine Isolationsschicht 1, die sich aus mehreren Keramikschichten zusammensetzt ist. Die Metallisierungsschicht 12 ist über eine Anbindungsfläche A an die Isolationsschicht 11 flächig angebunden. Beispielsweise weist die Isolationsschicht eine Isolationsschichtdicke ID bzw. erste Dicke zwischen 100 und 1000 μm auf und die Metallisierungsschicht eine Metallisierungsschichtdicke MD bzw. zweite Dicke von im Wesentlichen 0,6 mm.

Die Metallisierungsschicht 12 weist ferner auf der der Anbindungsfläche A gegenüberliegenden Seite eine Abschlussfläche AF auf, über die elektrische bzw. elektronische Bauteile an die Metallisierungsschicht 12 angeschlossen werden können. Die Anbindungsfläche A und die in einer senkrecht zur Hauptserstreckungsebene HSE verlaufenden Richtung gegenüberliegenden Abschlussfläche AF sind über Seitenfläche SF miteinander verbunden. Vorzugsweise wird die Abschlussfläche AF durch eine weitere Kante K' in einer parallel zur Hauptserstreckungsebene HSE verlaufenden Ebene begrenzt.

Insbesondere ist die Anbindungsfläche A in einer parallel zur Hauptserstreckungsebene durch eine Kante K begrenzt. D. h. die Kante K bildet an einer Sichtseite des Metall-Keramik-Substrats 1 einen linienförmigen Übergang zwischen der Metallisierungsschicht 12 und der Isolationsschicht 11. An die Kante K schließt sich in einer parallel zur Hauptserstreckungsebene HSE verlaufenden Richtung ein Randbereich RB der Metallisierungsschicht an. Eine sich parallel zur Hauptserstreckungsebene HSE verlaufende Länge L des Randbereichs RB zu einer in dieselbe Richtung bemessene Gesamtlänge M1 der Metallisierungsschicht 11 beträgt vorzugsweise weniger als 0,25, bevorzugt weniger als 0,15 und besonders bevorzugt weniger als 0,1.

In der in Figur 1 dargestellten Ausführungsform sind kuppelförmige Ausnehmungen 13 an der Abschlussfläche AF in die Metallisierungsschicht 12 im Randbereich RB eingelassen. Diese kuppelförmigen Ausnehmungen 13 stellen eine Materialschwächung dar. Neben der Materialschwächung ist es vorgesehen, dass die Kante K zumindest bereichsweise mit einem Füllmaterial 2 bedeckt ist. Es hat sich dabei herausgestellt, dass die Kombination von Materialschwächung im Randbereich RB und Bedeckung der Kante K mit einem Füllmaterial 2 synergetisch die Temperaturwechselbeständigkeit verbessert, d. h. die Kombination beider Maßnahmen verbessert die Temperaturwechselbeständigkeit mehr als die Verbesserung, die durch die beiden jeweils die Temperaturwechselbeständigkeit verbessernden Maßnahmen in ihrer Summe zu erwarten wäre.

Dabei ist es vorstellbar, dass eine senkrecht zu Hauptserstreckungsebene HSE bemessene Füllmaterialhöhe FH nicht der Metallisierungsschichtdicke MD entspricht, sondern kleiner ist. Vorzugsweise nimmt ein Verhältnis zwischen der Füllmaterialhöhe FH zu der Metallisierungsschichtdicke MD ein Wert zwischen 0,5 und 0,9, und bevorzugt zwischen 0,6 und 0,85 an. Mit anderen Worten. Die Seitenflächen SF bleiben zumindest teilweise frei von Füllmaterial mit einer Schichtstärke, die größer ist als 10 $\mu$m. Weiterhin ist es vorgesehen, dass sich zur Materialschwächung des Randbereichs RB die Seitenflächen SF schräg zu einer senkrecht zur Hauptserstreckungsebene HSE verlaufenden Richtung erstrecken.

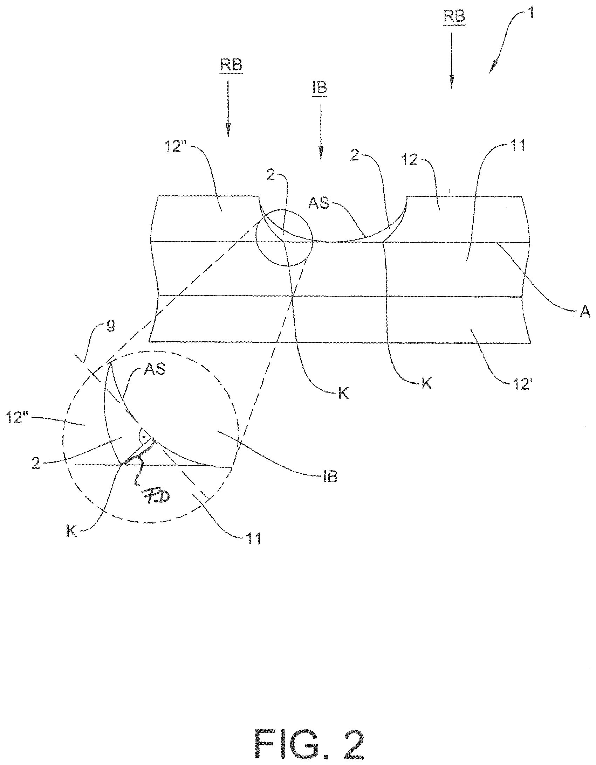

In Figur 2 ist ein Metall-Keramik-Substrat gemäß einer zweiten bevorzugten Ausführungsform der vorliegenden Erfindung dargestellt. Dabei unterscheidet sich die Ausführungsform aus der Figur 2 von derjenigen aus der Figur 1 dahingehend, dass die Seitenfläche SF gebogen ist. Eine solche gebogene Seitenfläche entsteht beispielsweise durch ein gezieltes Ätzen und stellt eine Materialschwächung des Randbereichs RB dar. Ferner zeigt die Figur 2 einen Isolationsgrabenbereich IB, der in einer parallel zur Hauptserstreckungsebene HSE verlaufenden Richtung zwischen der Metallisierungsschicht 12 und einer benachbarten Metallisierungsschicht 12" angeordnet ist. Ferner ist beispielhaft eine weitere Metallisierungsschicht 12' auf der der Metallisierungsschicht 12 bzw. der benachbarten Metallisierungsschicht 12" abgewandten Seite der Isolationsschicht 11 angeordnet. Insbesondere liegt der Isolationsgrabenbereich IB zwischen einer, in einer parallel zur Hauptserstreckungsebene HSE verlaufenden Richtung gesehen, Kante K der Metallisierungsschicht 12 und einer Kante K der benachbarten Metallisierungsschicht 12". Weiterhin ist das Füllmaterial 2 an seiner der Kante K abgewandten Außenseite AS gebogen ausgeformt. Dabei ist es vorzugsweise vorgesehen, dass sich eine Füllmaterialdicke FD entlang einer parallel zur Hauptserstreckungsebene HSE verlaufenden Richtung ändert. Dabei bemisst sich die Füllmaterialdicke FD in einer Richtung, die senkrecht zu einer gedachten Gerade g verläuft, die sich wiederum tangential an der von der Kante abgewandte Außenseite AS des Füllmaterials 2 erstreckt.

Vorzugsweise ist die Füllmaterialdicke FD im Bereich oberhalb der Kante K maximal (oberhalb bezieht sich dabei auf eine parallel zur Messrichtung verlaufenden Richtung) und nimmt mit zunehmend Abstand von der Kante K in einer parallel zur Hauptserstreckungsebene HSE verlaufenden Richtung ab. Vorzugsweise ist der Isolationsgrabenbereich IB zumindest partiell füllmaterialfrei, d. h. es gibt einen Bereich zwischen der Metallisierungsschicht 12 und der benachbarten Metallisierungsschicht 12", in dem kein Füllmaterial 2 vorgesehen ist. Es ist aber auch denkbar, dass die die Füllmaterialdicke zwischen der Metallisierungsschicht 12 und der benachbarten Metallisierungsschicht 12" einen Wert von weniger als 10 $\mu$m, bevorzugt weniger als 5 $\mu$m und besonders bevorzugt weniger als 1 $\mu$m aufweist.

Beispiel I:

Die folgenden Untersuchungen zur Temperaturwechselbeständigkeit wurden an Metall-Keramik-Substraten 1 vorgenommen, die eine

- Isolationsschicht 11 aus einer HPS9-Keramikschicht mit einer Isolationsschichtdicke ID von 0,32 mm und

- eine Metallisierungsschicht 12 und eine weitere Metallisierungsschicht 12' jeweils aus einer 0,6 mm Kupferschicht

    aufweisen. Hierzu wurden die Untersuchungen zur Temperaturwechselbeständigkeit zwischen -55 °C und 150°C durchgeführt.

    Als Materialschwächung wurden kuppelförmige Aussparungen 13 in den Randbereich RB in die Metallisierungsschicht 12 eingelassen und als Füllmaterial 2 eine Epoxidharz verwendet. Die Untersuchungen zur Temperaturwechselbeständigkeit wurden durchgeführt für

- ein Metall-Keramik-Substrat Typ I, das nur die Materialschwächung aufweist und kein Füllmaterial 2,

- Metall-Keramik-Substrat Typ II, dessen Kante K mit einem Füllmaterial 2 bedeckt ist und keine Materialschwächung im Randbereich aufweist, und

- Metall-Keramik-Substrat Typ III, dessen Kante K mit einem Füllmaterial 2 bedeckt ist und die Materialschwächung in Form der kuppelförmigen Aussparungen 13 aufweist. Das Metall-Keramik-Substrat Typ I, Metall-Keramik-Substrat Typ II und Metall-Keramik-Substrat Typ III wurden jeweils einmal mit einem DCB Verfahren und einmal mit einem AMB Verfahren hergestellt.

Für das Metall-Keramik-Substrat Typ I zeigte sich eine Verbesserung der Temperaturwechselbeständigkeit von 100 %, wenn es mittels des AMB Verfahrens hergestellt wurde, oder keine Verbesserung, wenn es mittels des DCB-Verfahrens hergestellt wurde.

Für das Metall-Keramik-Substrat Typ II zeigte sich eine Verbesserung der Temperaturwechselbeständigkeit von 700 %, wenn es mittels DCB-Verfahrens hergestellt wurde, oder keine Verbesserung, wenn es mittels des AMB Verfahrens hergestellt wurde.

Für das Metall-Keramik-Substrat Typ III zeigte sich eine Verbesserung der Temperaturwechselbeständigkeit von 1500 %, wenn es mittels DCB Verfahren hergestellt wurde oder eine Verbesserung von 500 %, wenn es mittels des AMB Verfahrens hergestellt wurde.

Den Versuchen sind demnach folgende Ergebnisse zu entnehmen:

- eine Kombination der Materialschwächung und des Bedeckens der Kante K mit dem Füllmaterial wirkt sich synergetisch auf die Temperaturwechselbeständigkeit aus, und

- dieser synergetische Effekt hängt vom Herstellungsverfahren des Metall-Keramik-Substrats ab.

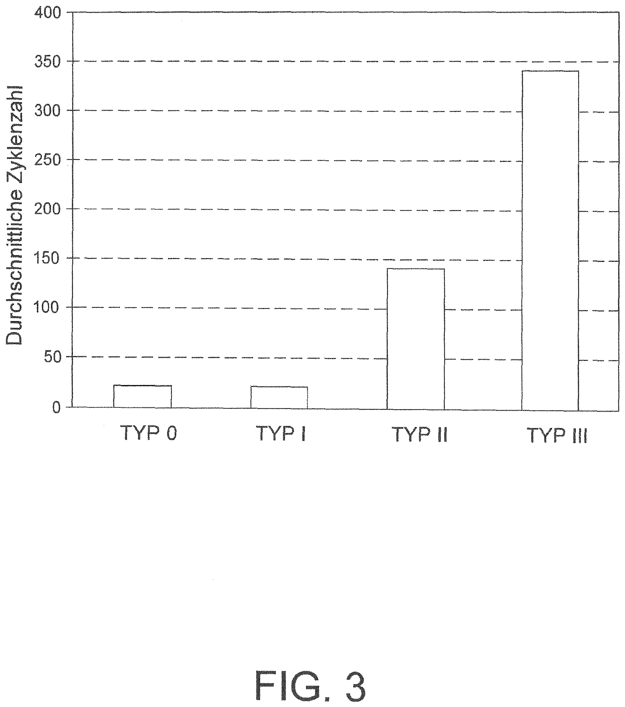

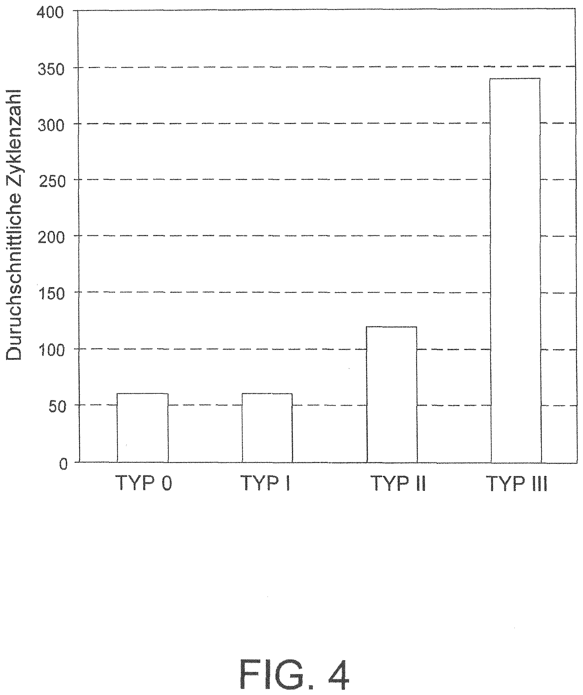

Die hier vorgestellten Versuchsergebnisse sind nochmals in den Figuren 3 und 4, dargestellt, in denen für die vorgenannten Metall-Keramik-Substrat- Typen jeweils die durchschnittliche Zykluszahl, nach der eine Delimination bzw. ein Einreißen der Isolationsschicht festgestellt wurde, in einem Balkendiagramm dargestellt sind. Innerhalb eines Zyklus wird dabei das jeweilige Metall-Keramik-Substrat einer Temperaturschwankung zwischen - 55 ° und 150 ° ausgesetzt und so die Anzahl der Zykluszahl, nach der eine Delimination bzw. ein Einreißen der Isolationsschicht festgestellt wird, erfasst. Die durchschnittliche Zykluszahl ist somit Maß für die Temperaturwechselbeständigkeit des Metall-Keramik-Substrats. Die Versuche haben zudem gezeigt, dass die Temperaturwechselbeständigkeit reduziert ist, wenn die Kante nicht vollständig, d. h. umlaufend, bedeckt ist. Als Typ 0 werden hierbei solche Metall-Keramik-Substrate erfasst, bei denen lediglich eine Anbindung über das DCB Verfahren oder AMB Verfahren erfolgte, ohne die Kante mit einem Füllmaterial zu bedecken und/oder eine Materialschwächung im Randbereich vorzunehmen. In der Figur 3 sind diejenigen für die mittels DCB-Verfahren hergestellten und in Figur 4 die mittels AMB-Verfahren hergestellten Metall-Keramik-Substrate illustriert.

Bezugszeichenliste:

| 1 | Metall-Keramik-Substrat |
| 2 | Füllmaterial |
| 11 | Isolationsschicht |
| 12 | Metallisierungsschicht |
| 12' | weitere Metallisierungsschicht |
| 12" | benachbarte Metallisierungsschicht |
| 13 | Aussparung |
| g | Gerade |
| HSE | Haupterstreckungsebene |
| K | Kante |
| K' | weitere Kante |
| FH | Füllmaterialhöhe |
| MD | Metallisierungsschichtdicke |
| RB | Randbereich |
| AS | Außenseite |
| IB | Isolationsgrabenbereich |
| FD | Füllmaterialdicke |
| SF | Seitenfläche |
| A | Anbindungsfläche |
| AF | Abschlussfläche |
| L | Länge des Randbereichs |
| M1 | Gesamtlänge der Metallisierungsschicht |

**Patentansprüche**

1.   Metall-Keramik-Substrat (1), umfassend

- eine sich entlang einer Haupterstreckungsebene (HSE) erstreckende und eine Keramik aufweisende Isolationsschicht (11) und
- eine Metallisierungsschicht (12), die an der Isolationsschicht (11) über einer Anbindungsfläche (A) angebunden ist, wobei die Anbindungsfläche (A) in einer parallel zur Haupterstreckungsebene (HSE) verlaufenden Ebene durch mindestens eine Kante (K) begrenzt ist, wobei die Kante (K) zumindest teilweise mit einem Füllmaterial (2) bedeckt ist und ein sich an die Kante (K) anschließender Randbereich (RB) der Metallisierungsschicht (12) eine Materialschwächung aufweist, und wobei die Materialschwächung als Aussparung (13) ausgebildet ist, **dadurch gekennzeichnet, dass**

- das Füllmaterial (2) die weitere Kante (K') übergreift und eine Aussparung (13) an der Oberseite der Metallisierung füllt und/oder
- ein Verhältnis zwischen der Metallisierungsdicke (MD) zur Füllmaterialhöhe (FH) einen Wert zwischen 0,5 und 0,9, bevorzugt zwischen 0,6 und 0,8 und besonders bevorzugt im Wesentlichen von 0,75 annimmt und/oder
- das Füllmaterial (2) in einer senkrecht zur Haupterstreckungsebene (HSE) verlaufenden Richtung bündig mit der weiteren Kante (K') abschließt.

2. Metall-Keramik-Substrat (1) gemäß Anspruch 1, wobei die Materialschwächung als kuppelförmige Aussparung (13) ausgebildet ist.

3. Metall-Keramik-Substrat (1) gemäß einem der vorhergehenden Ansprüche, wobei das Füllmaterial (2) bis zu einer weiteren Kante (K') reicht, die die Abschlussfläche (AF) der Metallisierung (12) in einer parallel zur Haupterstreckungsebene (HSE) verlaufenden Ebene an der Oberseite begrenzt.

4. Metall-Keramik-Substrat (1), umfassend

- eine sich entlang einer Haupterstreckungsebene (HSE) erstreckende und eine Keramik aufweisende Isolationsschicht (11) und
- eine Metallisierungsschicht (12), die an der Isolationsschicht (11) über einer Anbindungsfläche (A) angebunden ist, wobei die Anbindungsfläche (A) in einer parallel zur Haupterstreckungsebene (HSE) verlaufenden Ebene durch mindestens eine Kante (K) begrenzt ist, **dadurch gekennzeichnet,**

**dass** die Kante (K) zumindest teilweise mit einem Füllmaterial (2) bedeckt ist und ein sich an die Kante (K) anschließender Randbereich (RB) der Metallisierungsschicht (12) eine Materialschwächung aufweist und dass eine zur Haupterstreckungsebene (HSE) nicht parallele Seitenfläche (SF) der Metallisierungsschicht (12) zumindest abschnittsweise schräg und/oder bogenförmig verläuft.

5. Metall-Keramik-Substrat (1) gemäß einem der vorhergehenden Ansprüche, wobei das Füllmaterial (2) ein organisches Vergussmaterial, vorzugsweise mit einer Kurzzeittemperaturfestigkeit von mehr als 300 °C, umfasst.

6. Metall-Keramik-Substrat (1) gemäß einem der vorhergehenden Ansprüche, wobei das Füllmaterial (2), insbesondere an seiner dicksten Stelle, eine Füllmaterialdicke (FD) von mindestens 20 $\mu$m, bevorzugt mindestens 30 $\mu$m und besonders bevorzugt mindestens 40 $\mu$m, aufweist.

7. Metall-Keramik-Substrat (1) gemäß einem der vorhergehenden Ansprüche, wobei das Füllmaterial (2), insbesondere an seiner dünnsten Stelle, vorzugsweise zwischen der Metallisierungsschicht (12) und einer benachbarten Metallisierungsschicht(12"), eine Füllmaterialdicke (FD) von weniger als 30 $\mu$m, bevorzugt weniger als 20 $\mu$m und besonders bevorzugt weniger als 10 $\mu$m aufweist.

8. Metall-Keramik-Substrat (1) gemäß einem der vorhergehenden Ansprüche, wobei eine Füllmaterialdicke (FD) oberhalb der Kante (K) maximal ist und/oder in einer parallel zur Haupterstreckungsebene (HSE) verlaufenden Richtung abnimmt.

9. Verfahren zum Herstellen eines Metall-Keramik-Substrats (1) gemäß einem der vorhergehenden Ansprüche, umfassend die Schritte:

- Bereitstellen einer sich entlang einer Haupterstreckungsebene (HSE) erstreckenden und eine Keramik aufweisenden Isolationsschicht (11),
- Anbinden einer Metallisierungsschicht (12) unter Ausbildung einer Anbindungsfläche (A), die in einer parallel zur Haupterstreckungsebene (HSE) verlaufenden Ebene durch mindestens eine Kante (K) begrenzt ist, und
- Ausbildung einer Materialschwächung in der Metallisierungsschicht (12) in einem sich an die Kante (K) anschließenden Randbereich (RB),

wobei die Kante (K) mit einem Füllmaterial (2) bedeckt wird.

10. Verfahren gemäß einem der vorhergehenden Ansprüche, wobei die Metallisierungsschicht (12) mittels eines DCB-Verfahrens an die Isolationsschicht (11) angebunden wird.

**Claims**

1. A metal-ceramic substrate (1) comprising

- an insulation layer (11) extending along a main extension plane (HSE) and comprising a ceramic material, and
- a metallization layer (12) bonded to the insulation layer (11) via a bonding surface (A), the bonding surface (A) being limited by at least one edge (K) in a plane extending parallel to the main extension plane (HSE), the edge (K) being at least partially covered by a filler material (2) and an edge region (RB) of the metallization layer (12) adjoining the edge (K) having a material weakening, and the material weakening being formed as a recess (13), **characterized in that**
- the filler material (2) overlaps the additional edge (K') and filling a recess (13) on the upper side of the metallization and/or
- a ratio between the metallization thickness (MD) and the filler material height (FH) assumes a value between 0.5 and 0.9, preferably between 0.6 and 0.8 and particularly preferably substantially 0.75 and/or
- the filler material (2) is flush with the additional edge (K') in a direction perpendicular to the main extension plane (HSE).

2. The metal-ceramic substrate (1) according to claim 1, wherein the material weakening is formed as a dome-shaped recess (13).

3. The metal-ceramic substrate (1) according to one of the preceding claims, wherein the filler material (2) extends up to an additional edge (K') which limits the end face (AF) of the metallization (12) in a plane parallel to the main extension plane (HSE) on the upper side.

4. The metal-ceramic substrate (1) comprising

   - an insulation layer (11) extending along a main extension plane (HSE) and comprising a ceramic material, and
   - a metallization layer (12) bonded to the insulation layer (11) via a bonding surface (A), the bonding surface (A) being limited by at least one edge (K) in a plane extending parallel to the main extension plane (HSE), **characterized in in that** the edge (K) is at least partially covered by a filler material (2) and an edge region (RB) of the metallization layer (12) adjoining the edge (K) has a material weakening, and **in that** a lateral surface (SF) of the metallization layer (12) which is not parallel to the main extension plane (HSE) extends obliquely and/or arcuately at least in sections.

5. The metal-ceramic substrate (1) according to one of the preceding claims, wherein the filler material (2) comprises an organic potting material, preferably having a short-term temperature strength of more than 300 °C.

6. The metal-ceramic substrate (1) according to one of the preceding claims, wherein the filler material (2), especially at its thickest part, has a filler material thickness (FD) of at least 20 $\mu$m, preferably at least 30 $\mu$m and particularly preferably at least 40 $\mu$m.

7. The metal-ceramic substrate (1) according to one of the preceding claims, wherein the filler material (2), especially at its thinnest point, preferably between the metallization layer (12) and an adjacent metallization layer( 12"), has a filler material thickness (FD) of less than 30 $\mu$m, preferably less than 20 $\mu$m and particularly preferably less than 10 $\mu$m.

8. The metal-ceramic substrate (1) according to one of the preceding claims, wherein a filler material thickness (FD) is maximum above the edge (K) and/or decreases in a direction parallel to the main extension plane (HSE).

9. A method for producing a metal-ceramic substrate (1) according to one of the preceding claims, comprising the steps of:

   - providing an insulation layer (11) extending along a main extension plane (HSE) and comprising a ceramic material,
   - -bonding a metallization layer (12) to form a bonding surface (A) which is limited by at least one edge (K) in a plane parallel to the main extension plane (HSE), and
   - forming a material weakening in the metallization layer (12) in an edge region (RB) adjoining the edge (K),

   wherein the edge (K) is covered by a filler material (2).

10. The method according to one of the preceding claims, wherein the metallization layer (12) is bonded to the insulation layer (11) using a DCB process.

**Revendications**

1. Substrat métallo-céramique (1), comportant

   - une couche d'isolation (11) s'étendant le long d'un plan d'extension principale (HSE) et comprenant une céramique, et
   - une couche de métallisation (12) collée à la couche d'isolation (11) par l'intermédiaire d'une surface de collage (A), la surface de collage (A) étant délimitée par au moins un bord (K) dans un plan parallèle au plan d'extension principale (HSE), ledit bord (K) étant au moins partiellement recouvert d'un matériau de remplissage (2), et une zone de bord (RB), adjacente au bord (K), de la couche de métallisation (12) présentant un affaiblissement du matériau, et l'affaiblissement du matériau étant réalisé sous forme d'échancrure (13),
   **caractérisé en ce que**
   - le matériau de remplissage (2) coiffe l'autre bord (K') et remplit une échancrure (13) sur la face supérieure de la métallisation, et/ou

- un rapport entre l'épaisseur de métallisation (MD) et la hauteur de matériau de remplissage (FH) prend une valeur comprise entre 0,5 et 0,9, de préférence entre 0,6 et 0,8, et de manière particulièrement préférée sensiblement égale à 0,75, et/ou

- le matériau de remplissage (2) se termine à fleur de l'autre bord (K') dans une direction perpendiculaire au plan d'extension principale (HSE).

2. Substrat métallo-céramique (1) selon la revendication 1,
dans lequel l'affaiblissement du matériau est réalisé en particulier sous forme d'échancrure en forme de dôme (13).

3. Substrat métallo-céramique (1) selon l'une des revendications précédentes, dans lequel le matériau de remplissage (2) s'étend jusqu'à un autre bord (K') qui délimite la surface terminale (AF) de la métallisation (12) sur la face supérieure dans un plan parallèle au plan d'extension principale (HSE).

4. Substrat métallo-céramique (1), comportant

- une couche d'isolation (11) s'étendant le long d'un plan d'extension principale (HSE) et comprenant une céramique, et
- une couche de métallisation (12) collée à la couche d'isolation (11) par l'intermédiaire d'une surface de collage (A), la surface de collage (A) étant délimitée par au moins un bord (K) dans un plan parallèle au plan d'extension principale (HSE),

**caractérisé en ce que**
le bord (K) est au moins partiellement recouvert d'un matériau de remplissage (2), et une zone de bord (RB), adjacente au bord (K), de la couche de métallisation (12) présente un affaiblissement du matériau, et **en ce que** une surface latérale (SF), non parallèle au plan d'extension principale (HSE), de la couche de métallisation (12) s'étend au moins localement en oblique et/ou en arc.

5. Substrat métallo-céramique (1) selon l'une des revendications précédentes, dans lequel le matériau de remplissage (2) comprend un matériau d'enrobage organique, ayant de préférence une résistance à la température à court terme de plus de 300 °C.

6. Substrat métallo-céramique (1) selon l'une des revendications précédentes, dans lequel le matériau de remplissage (2) présente, en particulier à son emplacement le plus épais, une épaisseur de matériau de remplissage (FD) d'au moins 20 $\mu$m, de préférence d'au moins 30 $\mu$m et de manière particulièrement préférée d'au moins 40 $\mu$m.

7. Substrat métallo-céramique (1) selon l'une des revendications précédentes, dans lequel le matériau de remplissage (2) présente, en particulier à son emplacement le plus mince, de préférence entre la couche de métallisation (12) et une couche de métallisation adjacente (12"), une épaisseur de matériau de remplissage (FD) inférieure à 30 $\mu$m, de préférence inférieure à 20 $\mu$m et de manière particulièrement préférée inférieure à 10 $\mu$m.

8. Substrat métallo-céramique (1) selon l'une des revendications précédentes, dans lequel une épaisseur de matériau de remplissage (FD) au-dessus du bord (K) est maximale et/ou diminue dans une direction parallèle au plan d'extension principale (HSE).

9. Procédé de fabrication d'un substrat métallo-céramique (1) selon l'une des revendications précédentes, comprenant les étapes consistant à :

- fournir une couche d'isolation (11) s'étendant le long d'un plan d'extension principale (HSE) et comprenant une céramique,
- coller une couche de métallisation (12) pour former une surface de collage (A) qui est délimitée par au moins un bord (K) dans un plan parallèle au plan d'extension principale (HSE), et
- former un affaiblissement du matériau dans la couche de métallisation (12) dans une zone de bord (RB) adjacente au bord (K),

le bord (K) étant recouvert d'un matériau de remplissage (2).

10. Procédé selon l'une des revendications précédentes,
dans lequel la couche de métallisation (12) est collée à la couche d'isolation (11) par un procédé DCB.

# FIG. 1

FIG. 2

FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0632681 A2
- DE 102010024520 A1
- DE 102013013842 A1
- US 3744120 A
- DE 2319854 C2